# EUROPEAN PATENT APPLICATION

(11) **EP 2 130 953 A2**
(43) Date of publication of application: **09.12.2009**
(21) Application number: 09007408.9
(22) Date of filing: 04.06.2009
(51) Int. Cl.: C30B 15/02, C30B 25/02, C30B 29/06

(54) **Epitaxial silicon wafer and method for producing the same**

(30) Priority: 05.06.2008 JP 2008148566
(71) Applicant: SUMCO CORPORATION, Tokyo 105-8634 (JP)
(72) Inventor: Sugimoto, Seiji, Tokyo 105-8634 (JP); Takaishi, Kazushige, Tokyo 105-8634 (JP)
(74) Representative: Hössle Kudlek & Partner

(57) **Abstract**

To provide an epitaxial silicon wafer in which on growing an epitaxial film only on the front side of a large-sized wafer which is 450 mm or more in diameter, the wafer can be decreased in warpage to obtain a high intrinsic gettering performance and a method for producing the epitaxial silicon wafer.
Intrinsic gettering functions have been imparted to a silicon wafer which is 450 mm or more in diameter and 0.1 Ω•cm or more in specific resistance by introducing nitrogen, carbon or both of them to a melt on pulling up an ingot. Thereby, after the growth of an epitaxial film (12), a silicon wafer (11) is less likely to warp greatly.

## Description

### Technical Field

The present invention relates to an epitaxial silicon wafer having an epitaxial film only on the front side (one side) and a method for producing the epitaxial silicon wafer.

### Background Art

Silicon wafers are produced in various steps at which first a single crystal ingot (silicon single crystal) is pulled up by the CZ (Czochralski) method and the ingot is subjected to slicing, beveling, lapping, etching, mirror polishing and washing, for example. However, it is anticipated that as wafers become progressively larger in size, in association with production of the single crystal ingot and silicon wafers, there may be a greater difficulty in producing a defectless crystal (COP-frec crystal) due to technical problems of pulling up the ingot, yields and others.
Therefore, in order to make defectless the front side of a wafer on which a device is formed, hereinafter, such a method will become predominant that the vapor phase epitaxial method disclosed in Patent Document 1 (Japanese Unexamined Patent Publication No. H06-112120), for example, is used to grow an epitaxial film on the front side (mirror surface) of a large-sized wafer which is, for example, 450 mm or more in diameter.

### Summary of the Invention

However, where a bulk wafer (silicon wafer) is different in material from an epitaxial film or where a dopant contained in the bulk wafer is different in concentraton from that contained in the epitaxial film, an epitaxial silicon wafer will have the following problems. More specifically, since atoms forming the bulk wafer are different in lattice constant from atoms forming the epitaxial film, it is more likely that the silicon wafer and also the epitaxial silicon wafer will warp. These wafers will warp more greatly as they are increased in size (Patent Document 1).

Therefore, there is presented an idea that, as a silicon wafer adopted is, for example, a wafer obtained from a highly resistant boron-doped single crystal ingot (0.1 Ω·cm or more in specific resistance) in which the boron concentration is less than 2.7 × 10¹⁷atoms/cm³. Thereby, stress resulting from a difference in atomic radius between a bulk wafer and an epitaxial film is decreased, and when the epitaxial film is grown on the front side of the water, it is less likely that the wafer warps greatly. Further, since the epitaxial film is grown on a wafer lower in boron concentration, a dopant is dispersed outwardly from the back side of the wafer, thus suppressing the occurrence of auto-doping phenomena where the dopant penetrates the epitaxial film on a device forming face. Still further, it is known that boron inside the wafer becomes a seed growth of intrinsic gettering (IC). However, as compared with a wafer higher in boron concentration, a wafer lower in boron concentration is low in intrinsic gettering performance.

Thus, as a result of intensive research, the inventor has found that in production of an epitaxial silicon wafer, some intrinsic gettering functions may be imparted to a silicon wafer which is 450 mm or more in diameter and 0.1 Ω·cm or more (high resistance) in specific resistance. The inventor has also found that even a wafer, the one side of which is epitaxially grown, is less likely to warp greatly and provided with a high intrinsic gettering performance and has thus accomplished the present invention.

An object of the present invention is to provide an epitaxial silicon wafer in which on growing an epitaxial film only on the front side of a large-sized wafer which is 450 mm or more in diameter, the wafer can be decreased in warpage to obtain a high intrinsic guttering performance and a method for producing the epitaxial silicon wafer.

### Means for Solving the Problem

The invention described in claim 1 is an epitaxial silicon wafer in which an epitaxial film is grown only on the front side of a silicon wafer obtained by processing a silicon single crystal pulled up by the CZ method which is 450 mm or more in diameter and 0.1 Ω·cm or more in specific resistance, and the epitaxial silicon wafer in which the silicon wafer has intrinsic gettering functions.

According to the invention described in claim 1, intrinsic gettering functions arc imparted to a silicon wafer at a high resistance of 0.1 Ω·cm or more in specific resistance and 450 mm or more in diameter, thereby even a large-sized wafer which is 450 mm or more in diameter is less likely to warp greatly after the growth of an epitaxial film and is able to obtain a high intrinsic gettering performance.

The silicon wafer may be available in any size, as long as the diameter is 450 mm or more.
Single crystal silicon which is the same as the wafer may be adopted as a material of the opitaxial film. Also, acceptable is a material different from the wafer, for example, gallium or arsenic.
The thickness of the epitaxial film is, for example, from several µm to 150 µm for high polar devices or power devices and 10 µm or less for MOS devices.

Any epitaxial method may be adopted, for example, a vapor phase epitaxial method, a liquid phase epitaxial method or a solid phase epitaxial method. Of these methods, the vapor phase epitaxial method includes, for example, a normal-pressure vapor phase epitaxial method, a reduced-pressure vapor phase epitaxial method and an organic-metal vapor phase epitaxial method. In the vapor phase epitaxial method, for example, an opitaxial silicon wafer is kept horizontal (with the front side and the back side kept parallel to each other) and accommodated at a wafer accommodating part. Used is a susceptor which is circular in a planar view and able to place one sheet of the wafer. The vapor phase epitaxial method may include homoepitaxy in which the same material as a silicon wafer is epitaxially grown and heteroepitaxy in which a material different from the wafer such as (GaAs) is epitaxially grown.

A vapor phase epitaxial growth apparatus may be structured in any way as long as it is a one-side vapor phase epitaxial growth apparatus in which an epitaxial film can be grown only on one side of a silicon wafer. The vapor phase epitaxial growth apparatus may include a sheet type, or a pancake type, a barrel type, a hot-wall type and a cluster type capable of processing a plurality of silicon wafers at the same time.
A method for imparting intrinsic gettering functions to a silicon wafer includes, for example, doping of a nitrogen element in a range of 1 × 10¹³ to 1 × 10¹⁵ atoms/cm³ to a melt (silicon) and doping of a carbon element in a range of 1 × 10¹⁵ to 1 × 10 ¹⁷ atoms/cm³ to a melt.

The invention described in claim 2 is the cpitaxial silicon wafer of claim 1 in which the silicon wafer contains at least one of a nitrogen element in a range of 1 × 10¹³ to 1 × 10¹⁵ atoms/cm³ and a carbon element in a range of 1 × 10¹⁵ to 1 × 10 ¹⁷ atoms/cm³.

According to the invention described in claim 2, a silicon wafer contains any one of a nitrogen element in a range of 1 × 10¹³ to 1 × 10¹⁵ atoms/cm³, a carbon element in a range of 1 × 10¹⁵ to 1 × 10 ¹⁷ atoms/cm³ and both the nitrogen element and Lhe carbon element. Thereby, the wafer is less likely to warp greatly after the growth of an epitaxial film. As a result, it is possible to decrease the warpage of the wafer and also obtain a high intrinsic gettering performance.

The invention described in claim 3 is a method for producing an epitaxial silicon wafer in which an epitaxial film is grown only on the front side of a silicon wafer obtained from a silicon single crystal pulled up from a melt inside a crucible by the CZ method which is 0.1 Ω·cm or more in specific resistance and 450 mm or more in diame ter, and the method for producing the epitaxial silicon wafer in which intrinsic gettering functions are imparted to the silicon wafer by doping at least one of (1) a nitrogen element in a range of 1 × 10¹³ to 1 × 10¹⁵ atoms/cm³ to the melt and (2) a carbon element in a range of 1 × 10¹⁵ to 1 × 10 ¹⁷ atoms/cm³ to the melt.

According to the invention described in claim 3, intrinsic gettering functions are imparted to a high resistance large-sized silicon wafer which is 450 mm or more in diameter and 0.1 Ω·cm or more in specific resistance. More specifically, performed is at least one of doping of a nitrogen element in a range of 1 × 10¹³ to 1 × 10¹⁵ atoms/cm³ to a silicon melt, doping of a carbon clement in a range of 1 × 10¹⁵ to 1 × 10 ¹⁷ atoms/cm³ to the melt and doping of both the nitrogen element and the carbon element. Thereby, the wafer is less likely to warp greatly after the growth of the epitaxial film. As a result, it is possible to decrease the warpage of the wafer and obtain a high intrinsic gettering performance.

As a method for increasing the specific resistance of a silicon wafer, adopted is a method for adding a dopant such as boron or phosphorus to a silicon melt in a crucible when an ingot is pulled up. Other dopants such as arsenic and antimony may be added.
When the nitrogen element is doped to the melt at less than 1 × 10 ¹³ atmos/cm³, there is caused a drawback that the gettering performance is insufficient due to insufficient internal precipitation. Further, when in excess of 1 × 10¹⁵ atoms/cm³, there is caused a drawback that an epitaxial film is broken through due to excessive internal precipitation.

When the carbon element is doped to the melt at less than 1 × 10¹⁵ atoms/cm³, there is found a drawback that the gettering performance is insufficient. Further, when in excess of 1 × 10 ¹⁷ atoms/cm³, there is found a drawback that the epitaxial film is deteriorated in quality.

The invention described in claim 4 is the method for producing the epitaxial silicon wafer described in claim 3 in which after growth of the epitaxial film, the front side of the epitaxial film and the back side of the silicon wafer are polished at the same time.

According to the invention described in claim 4, after growth of the epitaxial film, the front side of the epitaxial film and the back side of the silicon wafer are polished at the same time, by which both sides of the epitaxial silicon wafer can be increased in planarization. It is also possible to reduce the time necessary in the step of polishing the epitaxial film on both sides of the wafer and to increase the productivity.

As a method for polishing both the front side and the back side of an epitaxial silicon wafer, adopted is a sheet-type double side polishing method in which an epitaxial silicon wafer is polished on the front side and the back side at the same time between a lower surface plate having a polishing cloth stretched out on the upper face and an upper surface plate having a polishing cloth stretched out on the lower face. Further, there may be adopted a double side polishing method in which no sun gear is used and a carrier plate having an epitaxial silicon wafer accommodated at a wafer retaining hole is allowed to perform circular movements not in conjunction with rotation on its own axis between a polishing cloth-equipped lower surface plate and a polishing cloth-equipped upper surface plate.

### Effects of the Invention

According to the inventions described in claim 1 and claim 3, intrinsic gettering functions are imparted to a large-sized and high-resistant silicon wafer which is 450 mm or more in diameter and 0.1 Ω·cm or more in specific resistance, thereby the wafer is less likely to warp greatly after the growth of an epitaxial film. As a result, it is possible to decrease the warpage of the epitaxial silicon wafer and also obtain a high intrinsic gettering performance.

In particular, according to the invention described in claim 4, after the growth of the epitaxial film, the front side of the epitaxial film and the back side of the silicon wafer are polished at the same time. Thereby, the epitaxial silicon wafer can be increased in planarization on both sides, and also the time necessary in the step of polishing the epitaxial film on both sides of the wafer can be reduced to increase the productivity.

### Brief Description of the Drawings

Figure 1 is a cross sectional view of an epitaxial silicon wafer ot an example 1 in the present invention,
Figure 2 is a flow sheet showing a method for producing the epitaxial silicon wafer of the example 1 in the present invention.
Figure 3 is a longitudinal cross sectional view of a silicon single crystal growth apparatus used in a method for producing the epitaxial silicon wafer of the example 1 in the present invention.
Figure 4 is a perspective view of a double side polishing machine which is structured so as to be free of a sun gear and used in a method for producing the epitaxial silicon wafer of the example 1 in the present invention.
Figure 5 is a longitudinal cross sectional view showing the double side polishing machine which is structured so as to be free of a sun gear and used in a method for producing the epitaxial silicon wafer of the example 1 in the present invention.
Figure 6 is an enlarged cross sectional view of major parts of an epitaxial growth apparatus used in a method for pro ducing the epitaxial silicon wafer of the example 1 in the present invention.

### Best Mode for Carrying Out the Invention

Hereinafter, a description will be given specifically for the example of the present invention.

### Example

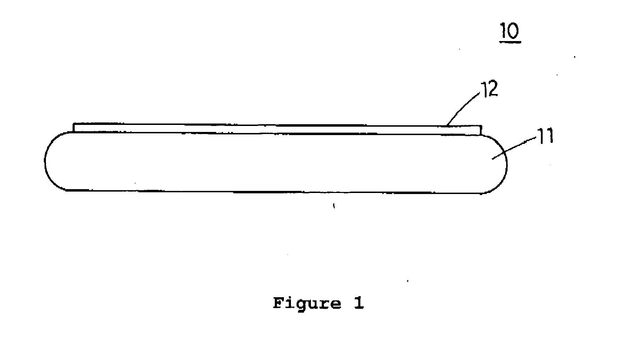

In Figure 1, the numcral 10 depicts an epitaxial silicon wafer of the example 1 in the present invention. The epitaxial silicon wafer 10 is based on a silicon wafer 11 which is obtained by processing a silicon single crystal pulled up by the CZ method so as to be 450 mm in diameter and 1.0 Ω·cm in specific resistance by boron dope. The epitaxial silicon wafer 10 is a two-layer structured wafer of which an epitaxial film 12 made up of single crystal silicon is grown by a vapor phase epitaxial method only on the front side of the silicon wafer 11. In order to impart intrinsic gettering functions, a nitrogen element is doped in a range of 1 × 10¹⁴ atoms/cm³ to the silicon wafer 11.

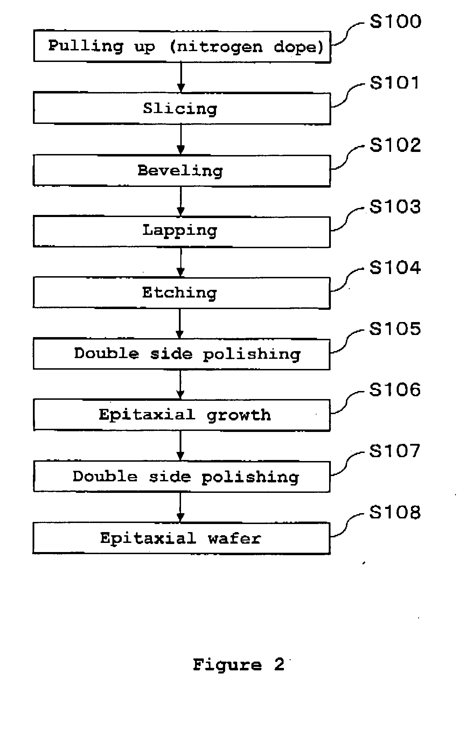

Hereinafter, a description will be given for a method for producing the epitaxial silicon wafer of the example 1 in the present invention by referring to the flow chart of Figure 2.
As illustrated in the flow chart of Figure 2, the silicon wafer 11 is produced in steps at which a single crystal silicon ingot is pulled up by the CZ method from a silicon melt to which horon is doped at a predetermined amount inside a crucible (S100), thereafter, the ingot is sliced into many wafers (S101), each of the wafers is subsequently subjected to beveling (S102), lapping (S103), etching (S 104) and double side polishing (S105).
Next, the epitaxial film 12 is grown on the front side of the silicon wafer 11 by a vapor phase epitaxial method (S106). Thereafter, the front side of the epitaxial film 12 and the back side of the silicon wafer 11 are polished at the same time (S107). Thereby, produced is the epitaxial silicon wafer 10 (S108).

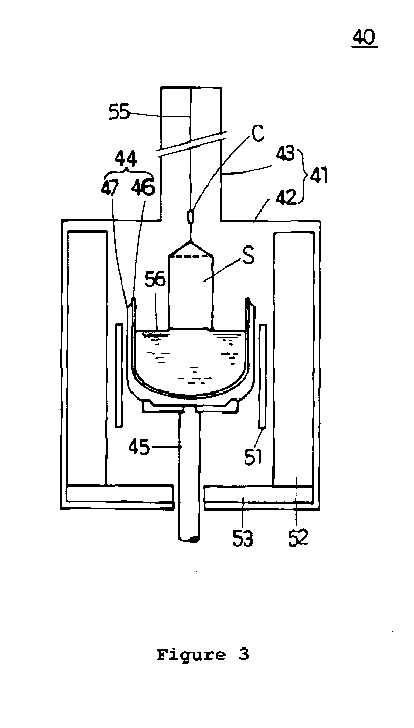

A description will be given specifically for individual steps.
In the step of pulling up the ingot (S100), a crystal growth apparatus shown in Figure 3 is used to grow a silicon single crystal. The thus produced silicon single crystal is 470 mm in diameter at the trunk part thereof which is sufficient in forming a 450 mm-sized silicon wafer.
In Figure 3, the number 40 depicts a silicon single crystal growth apparatus (hereinafter referred to as a crystal growth apparatus) used in the example 1 of the present invention. The crystal growth apparatus 40 is provided with a chamber 41 formed in a hollow cylindrical shape. The chamber 41 is made up of a main chamber 42 and a pull chamber 43 which is continuously fixed on the main chamber 42 and smaller in diameter than the main chamber 42. At the center inside the main chamber, a crucible 44 is fixed on a supporting shaft 45 (pedestal) which can rotate and move up and down freely. The crucible 44 has a double structure in combination with a quartz crucible 46 on the inside with a graphite crucible 47 on the outside.

A thermal resistance type heater 51 is arranged outside the crucible 44 so as to be concentric with respect to the wall of the crucible 44. A cylindrical thermal insulalion tube 52 is arranged outside the heater 51 along the inner face of the circumferential wall of the main chamber 42. A circular thermal insulation plate 53 is arranged on the bottom face of the main chamber 42.
A pulling-up shaft 55 capable of rotating and moving up and down on the same shaft with respect to the supporting shaft 45 (a wire will do) is hung through the pull chamber 43 on the center line of the crucible 44. A seed crystal C is loaded at the lower end of the pulling-up shaft 55.

Next, a description will be given specifically for a method for growing a silicon single crystal by using the crystal growth apparatus 40.
A silicon raw material for crystallization and boron for an impurity are fed into the crucible 44 so as to give 1.0 Ω·cm in specific resistance of the silicon single crystal S. Pressure inside the chamber 41 is reduced to 25 Torr, and argon gas which contains nitrogen gas in 100 L/min is introduced thereinto. Next, a resultant inside the crucible 44 is dissolved by the heater 51 to form a melt 56 inside the crucible 44.
Further, the seed crystal C loaded at the lower end of the pulling up shaft 55 is submerged into the melt 56, and the pulling-up shaft 55 is pulled up axially while the crucible 44 and the pulling-up shaft 55 are allowed to rotate in the reverse direction with respect to one another, thus growing the silicon single crystal S below the seed crystal C. Thereby, obtained is a silicon single crystal (ingot) S which is 1 × 10¹⁴ atoms/cm³ in nitrogen element and 1.0 Ω·cm in specific resistance by boron dope.

In the slicing step (S101), a wire saw in which a wire is wound around three group rollers arranged in a triangular shape when viewed from the side is used. The wire saw slices many silicon wafers 11 from the silicon single crystal S.
In the subsequent beveling step (S102), a beveling grind stone in rotation is pressed against an outer circumference of the silicon wafer 11 to effect beveling.
Tn the lapping step (S103), a double side lapping machine is used to lap both sides of the silicon wafer 11 at the same time. More specifically, both sides nf the silicon wafer 11 are lapped between the upper and the lower surface plates rotating at a predetermined speed.
In the etching step (S104), the silicon wafer 11 after lapping is submerged into an acid etching solution pooled in an etching tank to effect etching, thereby removing damage resulting from the beveling and the lapping.

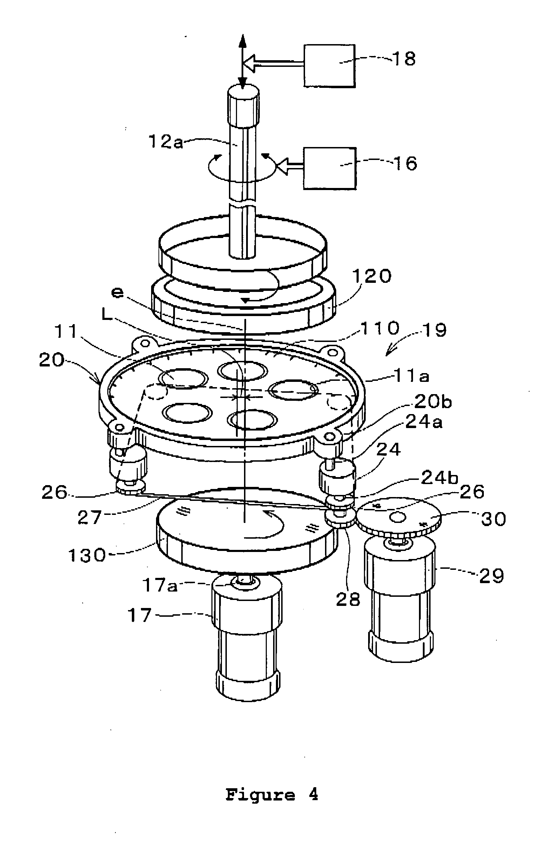

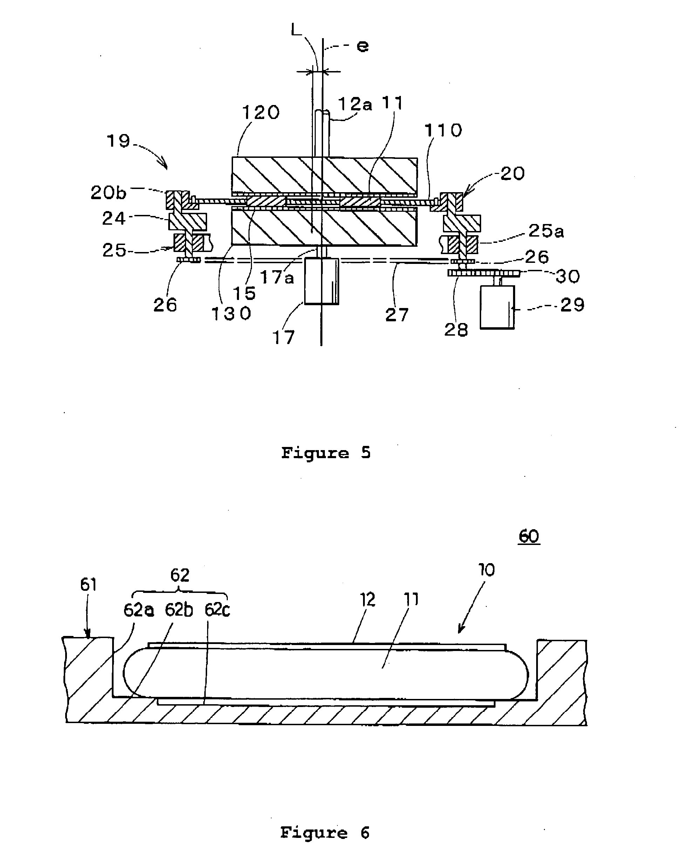

In the double side polishing step (S105), a double side polishing machine free of a sun gear is used to mirror-polish the both sides of the silicon wafer 11 at the same time.
Hereinafter, a description will be given specifically for a structure of the double side polishing machine structured so as to be free of a sun gear by referring to Figure 4 and Figure 5.
As shown in Figure 4 and Figure 5, an upper surface plate 120 is rotated and driven within a horizontal plane via a rotating shaft 12a extending upward by an upper-side rotating motor 16. Further, the upper surface plate 120 is caused to vertically move up and down by an elevating machine 18 moving back and forth axially. The elevating machine 18 is used when the epitaxial silicon wafer 11 is fed to and discharged from the carrier plate 110. It is noted that both the front and back sides of the epitaxial silicon wafer 11 on the upper surface plate 120 and the lower surface plate 130 are pressed by pressure means such as airbag-type means (not illustrated) assembled into the upper surface plate 120 and the lower surface plate 130. The lower surface plate 130 is rotated via the output shaft 17a thereof within a horizontal plane by a lower-side rotating motor 17. The carrier plate 110 moves circularly within a face (horizontal plane) parallel with the surface of the plate 110 by a carrier circular movement mechanism 19 so that the plate 110 itself will not rotate on its own axis.

The carrier circular movement mechanism 19 is provided with an annular carrier holder 20 for holding the carrier plate 110 from outside. The carrier circular movement mechanism 19 is connected to the carrier holder 20 via a connecting structure.
Four bearing units 20b projected outward at every 90 degrees are placed on an outer circumference of the carrier holder 20. An eccentric shaft 24a installed in a projecting manner at an eccentric position of the upper face of an eccentric arm 24 formed in a small-sized circular disk shape is inserted into each of the bearing units 20b. Further, a rotating shaft 24b is installed vertically at the center of the lower face of each of these four occentric arms 24. These rotating shafts 24b are inserted into four bearing units 25a which are placed at every 90 degrees on an annular base 25, with the respective leading ends projected downward. Sprockets 26 are firmly fixed to the respective leading ends of the rotating shafts 24b projected below. A timing chain 27 is hung over on cach of the sprockets 26 continuously in a horizontal state. These four sprockets 26 and the timing chain 27 cause the four rotating shafts 24b to rotate at the same time so that the four eccentric arms 24 move circularly in synchronization.

Of these four rotating shafts 24b, one of them is formed in a longer shape, and the leading end thereof projects further below than the sprocket 26, at which a gear 28 for power transmission is firmly fixed. The gear 28 is meshed with a large-sized driving gear 30 firmly fixed on an output shaft of a circular movement motor 29 extending upward.
Therefore, on actuation of the circular movement motor 29, the rotating force thereof will be transmitted to the timing chain 27 via the gears 30, 28 and the sprocket 26 firmly fixed to the longer rotating shaft 24b. The timing chain 27 rotates circumferentially, by which the four eccentric arms 24 rotate at the center of the rotating shaft 24b within a horizontal plane in synchronization via the other three sprockets 26. Thereby, the carrier holder 20 connected together with each of the eccentric shafts 24a and a carrier plate 110 held by the holder 20 perform circular movements without rotation on its own axis within a horizontal plane parallel with the plate 110. More specifically, the carrier plate 110 rotates, with such a state kept that it is eccentric only by a distance L from an axis line e between the upper surface plate 120 and the lower surface plate 130. The polishing cloth 15 is stretched out on each face opposing the surface plates 120, 130. The distance L is equal to a distance between the eccentric shaft 24a and the rotating shaft 24b. The circular movements without rotation on its own axis allow all points on the carrier plate 110 to exhibit a small-circular locus equal in dimension. Thereby, the silicon wafer 11 accommodated at a wafer accommodating portion 11a formed on the carrier plate 110 is polished on the both sides.

Next, a description will be given specifically for the epitaxial growth step (S106) by using a sheet-type vapor phase epitaxial growth apparatus by referring to Figure 6. As shown in Figure 6, the vapor phase epitaxial growth apparatus 60 is that in which a susceptor 61 which is circular in a planar view and capable of placing one sheet of a silicon wafer 11 is placed horizontally at the center of a chamber having a heater at the upper and the lower parts thereof. The susceptor 61 is fabricated by coating a carbon-made base material with SiC.
A recessed counterbore (wafer accommodating portion) 62 which accommodates the silicon wafer 11 in a horizontally kept state (a state in which the front side and the back side are in a horizontal position) is formed at an inner circumference on the upper face of the susceptor 61. The counterbore 62 is made up of a circumferential wall 62a, a 6 mm-wide step 62b which is annular in a planar view and a bottom plate (bottom wall face of the counterbore) 62c. A gas supply port which allows a predetermined carrier gas (H₂ gas) and predetermined source gas (SiHCl₃ gas) to flow parallel with the front side of the wafer at an upper space hollow of the chamber is placed at one side portion of the chamber. Further, a gas discharge port is formed on the other side portion of the chamber.

On expitaxial growth, the silicon wafer 11 is laid laterally on the counterbore 62, with the front side and the back side of a wafer kept horizontal. Next, an epitaxial film 12 is grown on the front side of the silicon wafer 11. More specifically, the carrier gas and the source gas are introduced into a reaction chamber through corresponding gas supply ports. The pressure inside the chamber is kept at 100 ± 20 KPa and silicon formed by thermal decomposition or reduction of the source gas is deposited at the reaction speed of 3.5 to 4.5 µm/minute on the silicon wafer 11 heated at high temperatures of 1000°C to 1150°C. Thereby, the epitaxial film 12 which is approximately 10 µm in thickness of the silicon single crystal is formed on the front side of the silicon wafer 11. Thus, produced is the epitaxial silicon wafer 10.

In the subsequent simultaneous polishing step of the epitaxial silicon wafer 10 (S107), a double side polishing machine structured so as to be free of a sun gear which is used in the double side polishing sep (S105) is used to mirror-polish the front side of the epitaxial film 12 and the back side of the silicon wafer 11 at the same time. Thus, produced is the epitaxial silicon wafer 10 (S108).

As described so far, intrinsic gettering functions are imparted to the silicon wafer 11 which is 0.1 Ω·cm in specific resistance and 450 mm in diameter. Therefore, even a large-sized silicon wafer 11 which is 450 mm in diameter is decreased in stress due to a difference in atomic radius between the bulk wafer 11 and the epitaxial film 12 on growth of the epitaxial film 12. Thereby, even when the epitaxial film 12 is grown only on the front side of the wafer on which a device is formed, it is less likely that the silicon wafer 11 and also the epitaxial silicon wafer 10 will warp greatly. Thus, it is possible to decrease the warpage of the epitaxial silicon wafer 10. Further, since the epitaxial film 12 is grown on the silicon wafer 11 lower in boron concentration, a dopant is dispersed outwardly from the back side of the wafer, thus suppressing the occurrence of auto-doping phenomena where the dopant penetrates the epitaxial film 12 on which a device is formed.

A nitrogen element at 1 × 10¹⁴ atoms/cm³ has been doped to the silicon wafer 11. As a result, although the silicon wafer 11 is a high resistant wafer lower in boron concentration, it is provided with a high intrinsic gette ring performance.
Further, after the epitaxial growth step, a double side polishing machine structured so as to be free of a sun gear is used to polish the front side of the epitaxial film 12 and the back side of the silicon wafer 11 at the same time. Thereby, the epitaxial silicon wafer 10 can be increased in planarization. Further, the time necessary for the polishing can be reduced to increase the productivity.

It is noted that the front side of the epitaxial film 12 and the back side of the silicon wafer 11 are not polished at the same time but may be polished by one side separately. In the example 1, as a method for imparting intrinsic gettering functions to the silicon wafer 11, there is adopted a method in which the nitrogen element at 1 × 10¹⁴ atoms/cm³ is doped to the melt 56. However, in place of this method, there may be adopted a method in which carbon powder may be added so as to give 1 × 10¹⁷ atoms/cm³ to the melt 56. Further, both the nitrogen dope and the carbon dope may be performed.

### Description of Reference Numerals

10: epitaxial silicon wafer
11: silicon wafer
12: epitaxial film
44: crucible
56: melt
S: silicon single crystal

## Claims

1. An epitaxial silicon water, wherein an epitaxial film is grown only on the front side of a silicon wafer obtained by processing a silicon single crystal pulled up by the CZ method which is 450 mm or more in diameter and 0.1 Ω·cm or more in specific resistance, and
the epitaxial silicon wafer, wherein the silicon wafer has intrinsic gettering functions.

2. The epitaxial silicon wafer as set forth in claim 1, wherein the silicon wafer contains at least one of a nitrogen element in a range of 1 × 10¹³ to 1 × 10¹⁵ atoms/cm³ and a carbon element in a range of 1 × 10¹⁵ to 1 × 10¹⁷ atoms/cm³.

3. A method for producing an epitaxial silicon wafer, wherein an epitaxial film is grown only on the front side of a silicon wafer obtained from a silicon single crystal pulled up from a melt inside a crucible by the CZ method which is 0.1 Ω·cm or more in specific resistance and 450 mm or more in diameter, and
the method for producing the epitaxial silicon wafer, wherein intrinsic gettering functions are imparted to the silicon wafer by doping at least one of (1) a nitrogen element in a range of 1 × 10¹³ to 1 × 10¹⁵ atoms/cm³ to the melt and (2) a carbon element in a range of 1 × 10¹⁵ to 1 × 10¹⁷ atoms/cm³ to the melt.

4. The method for producing the epitaxial silicon wafer as set forth in claim 3, wherein after the growth ot the epitaxial film, the front side of the epitaxial film and the back side of the silicon wafer are polished at the same time.
